(19) Europäisches Patentamt
European Patent Office
Office européen des brevets

(11) **EP 1 564 894 B1**

(12) **EUROPEAN PATENT SPECIFICATION**

(45) Date of publication and mention
of the grant of the patent:
**12.01.2011 Bulletin 2011/02**

(51) Int Cl.:
***H03M 13/39*** *(2006.01)*     ***H03M 13/45*** *(2006.01)*

(21) Application number: **04290424.3**

(22) Date of filing: **17.02.2004**

(54) **Method and device for sequence estimation**

Verfahren und Vorrichtung zur Sequenzschätzung

Procédé et dispositif d'estimation de séquence

(84) Designated Contracting States:
**DE FR GB IT**

(43) Date of publication of application:
**17.08.2005 Bulletin 2005/33**

(73) Proprietor: **STMicroelectronics N.V.**
**1118 BH Schiphol Airport Amsterdam (NL)**

(72) Inventors:
• **Wellig, Armin**
 **1260 Nyon (CH)**
• **Zory, Julien**
 **01210 Fernay Voltaire (FR)**

(74) Representative: **Zapalowicz, Francis**
**Casalonga & Partners**
**Bayerstrasse 71/73**
**80335 München (DE)**

(56) References cited:
**US-A- 4 933 956**

• **KOKKONEN M ET AL: "Soft-decision decoding of binary linear block codes using t-algorithm" PROC. OF THE INTERNATIONAL SYMPOSIUM ON PERSONAL, INDOOR AND MOBILE RADIO COMMUNICATIONS 1997. HELSINKI, FINLAND, 1 September 1997 (1997-09-01), pages 1181-1185, XP010247633 ISBN: 0-7803-3871-5**
• **SIMMONS S J: "BREADTH-FIRST TRELLIS DECODING WITH ADAPTIVE EFFORT" IEEE TRANSACTIONS ON COMMUNICATIONS, IEEE INC. NEW YORK, US, vol. 38, no. 1, 1990, pages 3-12, XP000102576 ISSN: 0090-6778**
• **LEE W-T ET AL: "A SINGLE-CHIP VITERBI DECODER FOR A BINARY CONVOLUTIONAL CODE USINGAN ADAPTIVE ALGORITHM" IEEE TRANSACTIONS ON CONSUMER ELECTRONICS, IEEE INC. NEW YORK, US, vol. 41, no. 1, 1 February 1995 (1995-02-01), pages 150-159, XP000529220 ISSN: 0098-3063**
• **YUNGHSIANG S HAN ET AL: "EFFICIENT PRIORITY-FIRST SEARCH MAXIMUM-LIKELIHOOD SOFT-DECISION DECODING OF LINEAR BLOCK CODES" IEEE TRANSACTIONS ON INFORMATION THEORY, IEEE INC. NEW YORK, US, vol. 39, no. 5, 1 September 1993 (1993-09-01), pages 1514-1523, XP000417580 ISSN: 0018-9448**

EP 1 564 894 B1

**Description**

The invention relates to estimating a sequence of bits corresponding to a received sequence of symbols.

An application of the invention is directed to the field of wireless communication systems, and more particularly to the 3GPP systems.

The article of Mikko Kokkonen et al. "Soft-Decision Decoding of Binary Linear Block Codes Using t-Algorithm", 1997 IEEE, pages 1181-1185, discloses a soft decision decoding algorithm for binary linear block codes. It uses the tree representation of a systematically encoded block code. The tree representation is traversed through in a breadth-first fashion and it is adaptively pruned during the decoding using the following principle: if the metric difference between the best partial path and any other partial path at the same level is greater than a threshold value, then such a path is not extended any further. The threshold value is chosen based on a signal-to-noise ratio estimate. The efficiency of the pruning procedure is enhanced by constructing the tree so that the most reliable symbols are processed first.

Physical control layer contains information necessary to configure physical channel parameters at the receiving end of a wireless communication system.

The control information needs to be decoded prior to the processing of the actual data samples composed of payload information provided by higher layers. Control bits are either transmitted prior to the payload or in parallel. In general, to minimize the synchronisation efforts, size of latency buffers and reduction of system throughput, the configuration, or reconfiguration of the receiver needs to be accomplished as fast as possible. Therefore, a latency constraint decoding and configuration problem has to be solved, where only a few bits, or control bits, are to be decoded as fast as possible.

The reliability of the control information needs to be guaranteed, since the remaining payload processing becomes obsolete in case of erroneous control signaling. Error robustness can be guaranteed by adding redundancy to the control bits. Upon reception of encoded control information, the receiver feeds the data into the corresponding decoder to recreate an exact copy of the originally transmitted control bits. The drawback is a considerable increase in processing complexity to implement sophisticated algorithms. Moreover, the system designers can pick among various forward error correction techniques with different complexity and error correction characteristics. Forward error correction codes comprises linear block codes and convolutional codes.

The scarce bandwidth of the air interface coupled with the high amount of redundancy to guarantee reliable transmission limits the amount of control bits to be transmitted.

To further improve transmission reliability, a modulation scheme with advantageous distance properties among the different signal constellation points should be chosen. Simple modulation schemes such as BPSK (binary phase-shift keying) or QPSK (quaternary phase-shift keying) are ideal candidates for reliable transmission due to high SNR (signal-to-noise ratio) of adjacent symbols.

Wireless systems becoming more and more complex, the need for smaller, faster and more power-efficient solutions is the key challenge of future system-on-chip designs.

Conventional solutions are determining a sequence of bits from a reference sequence space comprising an important number of reference sequences, and that needs notably an important memory size. The method is known in literature as maximum-likelihood sequence estimation (MLSE). Despite of its exponential complexity, one key property of the MLSE decoding method is its inherent flexibility; that is, each sequence can be decoded in an optimum way no matter what encoding scheme was used. This decoding method only implies a one-to-one mapping between the bits before and after encoding. Needless to say, that this condition is mandatory to unambiguously decode the sequence at the receiving side.

The invention proposes a solution capable of reducing the reference sequence space used.

Different aspects and embodiments of the invention are defined in the appended claims.

So, it is proposed a method for estimating a sequence of N bits corresponding to a received sequence of M digital data. The method comprises the steps of :

a) determining candidate sequences of $M_{RS}$ digital data from a reduced reference sequence space comprising $2^{N_{RS}}$ reduced reference sequences of $M_{RS}$ reference digital data, $M_{RS}$ being inferior to M and $2^{N_{RS}}$ being inferior or equal to $2^N$ ;

b) making up each candidate sequence with remaining reference digital data to obtain at least one complete candidate sequence of M digital data ; and

c) determining said sequence of N bits from all the complete candidate sequences.

The memory size is thus reduced, as well as the number of computations. The amount by which the search space can be reduced depends on the properties of the forward error correction codes.

According to an embodiment, said determining step a) comprises :

- calculating for each reduced reference sequence a first correlation energy from said reduced reference sequence and the $M_{RS}$ first digital data of the received sequence ;
- determining a threshold from the maximum of all the calculated first correlation energies ; and
- taking into account said threshold for determining said candidate sequences.

In a first example, the threshold is the maximum of all the calculated first correlation energies.

In a second example, the threshold determining step comprises :

- determining the maximum of all the calculated first correlation energies ;
- making up the reduced reference sequence having said maximum of all the calculated first correlation energies, with a set of corresponding remaining reference sequence to obtain a complete reference sequence ;
- calculating the correlation energy from the remaining $M-M_{RS}$ digital data of the received sequence and the remaining $M-M_{RS}$ digital data of said made up reduced reference sequence ; and
- adding said maximum of all the calculated first correlation energies and said calculated correlation energy, in order to obtain said threshold.

In a preferred embodiment, said determining step a) comprises :

- calculating the maximum possible correlation energy from the remaining $M-M_{RS}$ digital data of the received sequence ;
- for each reduced reference sequence, adding its first correlation energy to said calculated maximum possible correlation energy, to obtain a second correlation energy ;
- comparing each second correlation energy with said threshold ; and
- selecting as candidates the reduced sequences having their second correlation energy superior to said threshold.

Said making up step b) may comprise, for each candidate sequence, reading a predetermined set of stored possible $M-M_{RS}$ remaining reference digital data, to obtain a complete candidate sequence of M digital data.

Said making up step b) may also comprise, for each candidate sequence, generating a set of possible $M-M_{RS}$ remaining reference digital data, to obtain a complete candidate sequence of M digital data.

In a preferred embodiment, said determining step c) comprises :

- calculating for each complete candidate sequence a complete correlation energy from said complete candidate sequence and the received sequence ;
- selecting a complete candidate sequence having the highest complete correlation energy ; and
- determining said sequence of N bits from said selected complete candidate. For example, after said selected complete candidate sequence has been determined, the sequence of N bits is obtained by one-to-one demapping by using for example a look-up table.

A system for estimating a sequence of N bits corresponding to a received sequence of M digital data is also proposed. The system comprises :

- first determining means for determining candidate sequences of $M_{RS}$ digital data from a reduced reference sequence space comprising $2^{N_{RS}}$ reduced reference sequences of $M_{RS}$ reference digital data, $M_{RS}$ being inferior to M and $2^{N_{RS}}$ being inferior or equal to $2^N$ ;
- making up means for making up each candidate sequence with remaining reference digital data to obtain at least one complete candidate sequence of M symbols ; and
- second determining means for determining said sequence of N bits from all the complete candidate sequences.

In a preferred embodiment, said first determining means comprise :

- first calculating means for calculating for each reduced reference sequence a first correlation energy from said reduced reference sequence and the $M_{RS}$ first digital data of the received sequence ;
- second calculating means for determining a threshold from the maximum of all the calculated first correlation energies ; and
- processing means for determining said candidate sequences, taking into account said threshold.

In a first example, the second calculating means are adapted for calculating said threshold as being the maximum of all the calculated first correlation energies.

In a second example, the second calculating means are adapted for :

- determining the maximum of all the calculated first correlation energies ;
- making up the reduced reference sequence having the maximum of all the calculated first correlation energies, with a set of corresponding remaining reference sequence to obtain a complete reference sequence ;
- calculating the correlation energy from the remaining $M-M_{RS}$ digital data of the received sequence ($r_0 r_1 ... r_{M-1}$) and the remaining $M-M_{RS}$ digital data of said made up reduced reference sequence ; and
- adding said maximum of all the calculated first correlation energies and said calculated correlation energy, in order to obtain said threshold.

In a worthwhile embodiment, said first determining means comprise :

- third calculating means for calculating the maximum possible correlation energy from the remaining $M-M_{RS}$ digital data of the received sequence ;
- adding means for adding, for each reduced reference sequence, its first correlation energy to said calculated maximum possible correlation energy, to obtain a second correlation energy ;
  and processing means comprise :
- comparing means for comparing each second correlation energy with said threshold ; and
- first selecting means for selecting as candidate the reduced sequences having their second correlation energy superior to said threshold.

In a preferred embodiment, said making up means comprise a memory for storing predetermined possible $M-M_{RS}$ remaining reference digital data, and reading means for reading, for each candidate sequence, said stored predetermined possible $M-M_{RS}$ remaining reference digital data, to obtain a complete candidate sequence of M digital data.

In a worthwhile embodiment, said making up means comprise generating means for generating, for each candidate sequence, a set of possible $M-M_{RS}$ remaining reference digital data, to obtain a complete candidate sequence of M digital data.

In a preferred embodiment, said second determining means comprise:

- fourth calculating means for calculating, for each complete candidate sequence, a complete correlation energy from said complete candidate sequence and the received sequence ;
- second selecting means for selecting a complete candidate sequence having the highest correlation energy ; and
- demapping means for determining the corresponding sequence of N bits from said selected complete candidate.

According to the invention, a receiving apparatus, in particular a cellular mobile phone, is also proposed. The receiving apparatus incorporates a system as above defined.

Other advantages and features of the invention will appear on examining the detailed description of embodiments, these being in no way limiting, and of the appended drawings in which :

- figure 1 shows a cellular mobile phone with a system according to an aspect of the invention ;
- figure 2 illustrates a system according to an aspect of the invention in its context ;
- figure 3 illustrates a first detailed embodiment of the system of the figure 2 ;
- figure 4 illustrates a second detailed embodiment of the system of the figure 2 ;
- figure 5 illustrates a method according to an aspect of the invention ;
- figure 6 illustrates a first example of the method of the figure 5 ; and
- figure 7 illustrates a second example of the method of the figure 5.

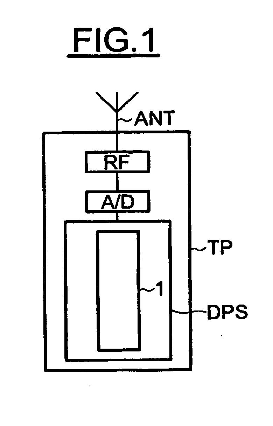

We refer now to figure 1 which illustrates a system according to an aspect of the invention, which is incorporated in the reception chain of a cellular mobile phone TP, although the invention is not limited to this particular application.

The interleaved signal is received by the antenna ANT and processed by the radio frequency stage RF of the receiver. At the output of the RF stage, the signal is converted into the digital domain by an A/D converter. The converted signal is transmitted to a digital process stage DPS which comprises a system 1 according to the invention, and processes the digital base band signal. The system 1 especially estimates a sequence of N bits $\hat{x}_0 \hat{x}_1 ... \hat{x}_{N-1}$ corresponding to a received sequence of M digital data or "soft bits" $r_0 r_1 ... r_{M-1}$.

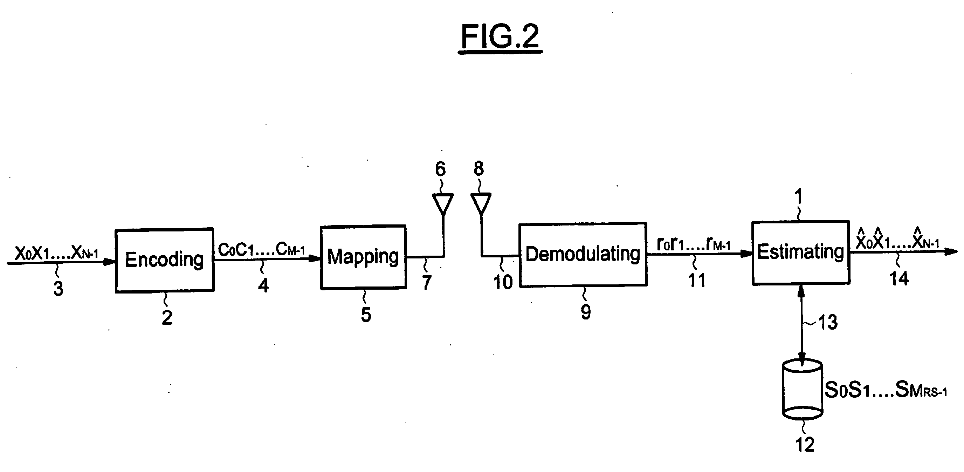

Referring to the figure 2, a system of communication comprising an estimating system 1 according to an aspect of the invention. An encoding module 2 receives a sequence $x_0 x_1 ... x_{N-1}$ of N bits by an input 3. The encoding module 2 outputs a corresponding encoded sequence $c_0 c_1 ... c_{M-1}$ of M bits, with a integer rate of encoding equal to n=M/N, and delivers said sequence through a connection 4 to a mapping module 5. The mapping module 5 outputs a corresponding mapped sequence of P symbols to the air by an antenna 6, where P equals to M divided by the number of encoded bits mapped to one constellation point, connected to the mapping module by a connection 7. A symbol is composed with a plurality of bits depending on the type of modulation used. The method applies to any modulation scheme, but thereafter we limit our discussion to BPSK, i.e. P=M, and QPSK, i.e. P=M/2 complex symbols implying P=M symbols comprised of a real and imaginary part that can be treated independently.

On the receiving side, an antenna 8 receives the mapped sequence and transmits it to a demodulating module 9 by a connection 10 which outputs a corresponding sequence $r_0 r_1 ... r_{M-1}$ of M digital data or "soft bits", by a connection 11, to the estimating system 1. In other words, a digital data or "soft bit" corresponds to a binary information encoded on several hard bits depending on the required precision. The value of each digital data or "soft bit" varies theoretically from $-\infty$ to $+\infty$.

A memory 12 contains a predetermined reduced reference sequence space comprising $2^{N_{RS}}$ reduced reference sequences of $M_{RS}$ reference digital data ($s_0 s_1 ... s_{M_{RS}-1}$), $M_{RS}$ and $N_{RS}$ being predetermined and $M_{RS}$ being inferior to M and $2^{N_{RS}}$ being inferior or equal to $2^N$, which reflects well the case of a convolutional encoder. The reduced reference sequences of $M_{RS}$ reference digital data are encoded with values of 1 and -1, or with values 0 and 1, according to the embodiment. The memory 12 is connected to the estimating system 1 by a connection 13.

The estimating module 1 outputs a sequence $\hat{x}_0 \hat{x}_1 ... \hat{x}_{N-1}$ of N bits by an output 14, the sequence $\hat{x}_0 \hat{x}_1 ... \hat{x}_{N-1}$ corresponding to a received sequence $r_0 r_1 ... r_{M-1}$ of M digital data, and so is an estimation of the initial sequence $x_0 x_1 ... x_{N-1}$ of N bits.

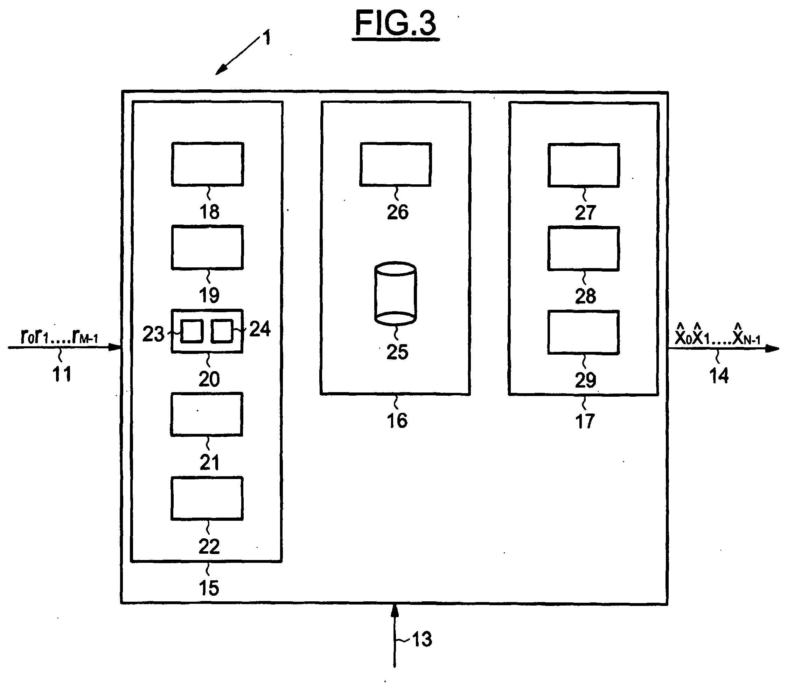

Figure 3 illustrates a detailed embodiment of the estimating system of the figure 2. The estimating system 1 comprises first determining means 15 for determining candidate sequences of $M_{RS}$ digital data from said reduced reference sequence space of $2^{N_{RS}}$ reduced reference sequences of $M_{RS}$ reference digital data ($s_0 s_1 ... s_{M_{RS}-1}$).

The estimating system 1 also comprises making up means 16 for making up each candidate sequence with remaining reference digital data to obtain at least one complete candidate sequence of M digital data.

The estimating system 1 further comprises second determining means 17 for determining the sequence of N bits ($\hat{x}_0 \hat{x}_1 ... \hat{x}_{N-1}$) from all the complete candidate sequences.

The first determining means 15 comprise first calculating means 18 for calculating for each reduced reference sequence a first correlation energy from said reduced reference sequence and the $M_{RS}$ first digital data of the received sequence $r_0 r_1 ... r_{M_{RS}-1}$.

The correlation energy of two sequences of k digital data is the sum of the products of the signed amplitudes of couples of digital data having the same rank. The same notation is used for a digital data and its energy.

So the first calculating means 18 calculate sequence a first correlation energy from a reduced reference sequence and the $M_{RS}$ first digital data of the received sequence $r_0 r_1 ... r_{M_{RS}-1}$ with the expression : $\sum_{i=0}^{M_{RS}-1} r_i . s_i$

The first determining means 15 also comprise second calculating means 19 for determining a threshold from the maximum of all the calculated first correlation energies, and processing means 20 for determining said candidate sequences, taking into account said threshold.

The first determining means 15 further comprise third calculating means 21 for calculating the maximum possible correlation energy $E_{max,end}^{M-M_{RS}}$ from the remaining $M-M_{RS}$ digital data of the received sequence $r_0 r_1 ... r_{M-1}$. This maximum possible correlation energy $E_{max,end}^{M-M_{RS}}$ is calculated, when a BPSK modulation is used with the relation :

$$E_{max,end}^{M-M_{RS}} = \sum_{i=M_{RS}}^{M-1} |r_i| \ , \ because \ |s_i| \leq 1$$

The first determining means 15 also comprise adding means 22 for adding, for each reduced reference sequence, its first correlation energy to the calculated maximum possible correlation energy $E_{max,end}^{M-M_{RS}}$, to obtain a second correlation energy.

The processing means 20 comprise comparing means 23 for comparing each second correlation energy with said threshold, and first selecting means 24 for selecting as candidate the reduced sequences having their second correlation energy superior to said threshold.

The making up means 16 comprise a memory 25 for storing predetermined possible $M-M_{RS}$ remaining reference digital data, and reading means 26 for reading, for each candidate sequence, the stored predetermined possible $M-M_{RS}$

remaining reference digital data, to obtain a complete candidate sequence of M digital data. This is for a use of a block code.

The second determining means 17 comprise fourth calculating means 27 for calculating, for each complete candidate sequence, a complete correlation energy from said complete candidate sequence and the received sequence $r_0 r_1 ... r_{M-1}$.

The second determining means 17 also comprise second selecting means 28 for selecting a complete candidate sequence having the highest correlation energy, and demapping means 29 for determining the corresponding sequence of N bits $\hat{x}_0 \hat{x}_1 ... \hat{x}_{N-1}$ from said selected complete candidate. This demapping is for example done with a look-up table.

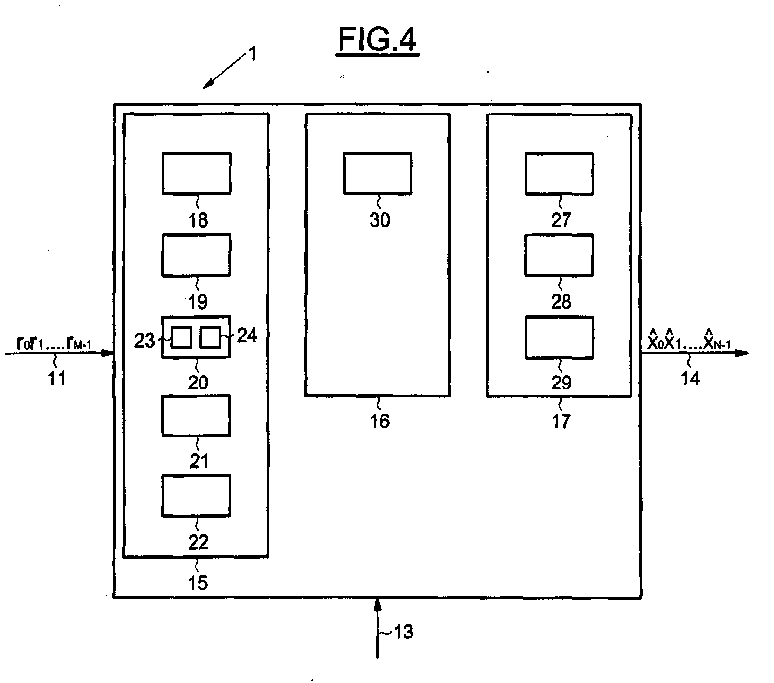

Referring to the figure 4, in case of use of a convolutional code, the making up means 16 may comprise generating means for generating, for each candidate sequence, a set of possible $M-M_{RS}$ remaining reference digital data, to obtain a complete candidate sequence of M digital data, instead of the memory 25 and the reading means 26. Indeed, in case of use of a convolutional code, it is easy to generate, for each candidate sequence, a set of possible $M-M_{RS}$ remaining reference digital data, to obtain a complete candidate.

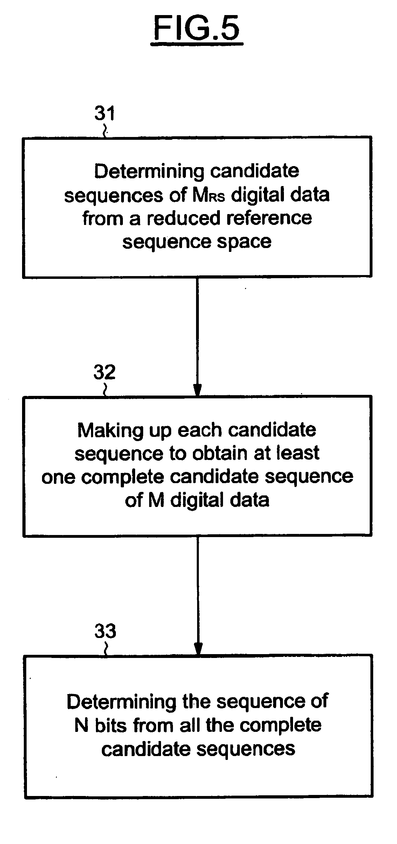

Referring to the figure 5, a method according to an aspect of the invention comprises a step 31 of determining candidate sequences of $M_{RS}$ digital data from a reduced reference sequence space comprising $2^{N_{RS}}$ reduced reference sequences of $M_{RS}$ reference digital data $s_0 s_1 ... s_{M_{RS}-1}$ by the first determining means 15.

Then, in a step 32, the making up means 16 make up each candidate sequence with remaining reference digital data to obtain at least one complete candidate sequence of M digital data.

Finally, in a step 33, the second determining means 17 determine the sequence of N bits $(\hat{x}_0 \hat{x}_1 ... \hat{x}_{N-1})$ from all the complete candidate sequences.

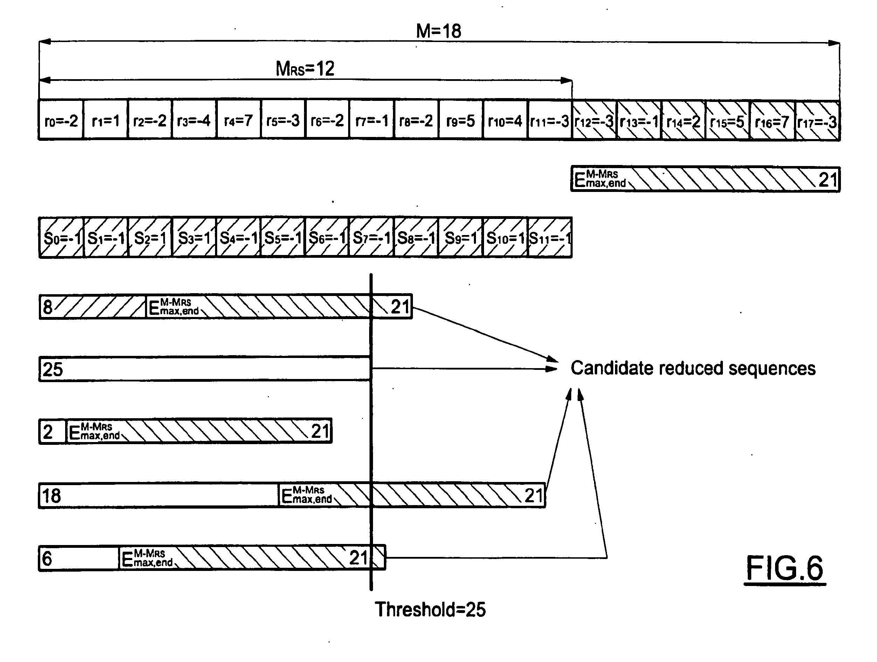

We will illustrate the method with a first concrete case, referring to the figure 6, with a simple modulation scheme BPSK. Of course other modulation schemes are possible.

In this case of M=18, $M_{RS}$=12, and $r_0 r_1 ... r_{M-1}$ is :

$r_0$=-2; $r_1$=1; $r_2$=-2; $r_3$=-4; $r_4$=7; $r_5$=-3; $r_6$=-2; $r_7$=-1; $r_8$=-2, $r_9$=5; $r_{10}$=4; $r_{11}$=-3;
and $r_{12}$=-3; $r_{13}$=-1; $r_{14}$=2; $r_{15}$=5; $r_{16}$=7; $r_{17}$=-3.

For each reduced reference sequence $s_0 s_1 ... s_{M_{RS}-1}$ of $M_{RS}$ digital data a calculate of a first correlation energy from said reduced reference sequence and the $M_{RS}$ first digital data of the received sequence $r_0 r_1 ... r_{M_{RS}-1}$ is done by the calculating means 18.

For example, for a reduced reference sequence which for example is related to $N_{RS}$ bits comprised of $x_0$=1 ; $x_1$=0 ; $x_2$=0 ; $x_3$=0 :

$s_0$=1; $s_1$=1; $s_2$=-1; $s_3$=-1; $s_4$=1; $s_5$=1; $s_6$=1; $s_7$=1; $s_8$=1, $s_9$=-1; $s_{10}$=-1; $s_{11}$=1;
the first correlation energy corresponding to said reduced reference sequence is:

$$\sum_{i=0}^{M_{RS}-1=11} r_i s_i = r_0.s_0 + r_1.s_1 + ... + r_{11}.s_{11}$$
$$= (-1)\times(-2)+(-1)\times(1)+(1)\times(-2)+(1)\times(-4)+(-1)\times(7)+(-1)\times(-3)$$
$$+(-1)\times(-2)+(-1)\times(-1)+(-1)\times(-2)+(1)\times(5)+(1)\times(4)+(-1)\times(-3)$$
$$= 2-1-2-4-7+3+2+1+2+5+4+3$$
$$= 8$$

This calculate is made for each reduced reference sequence of the reduced reference sequence space.
In this example, the calculate is made for four other reduced reference sequences, with results represented. The respective first correlation energies are 25, 2, 18, and 6.

The second calculating means 19 then determine the threshold as being the maximum $E_{max,beginning}^{M_{RS}}$ of all the calculated first correlation energies, here $E_{max,beginning}^{M_{RS}}=25$ for the reduced reference sequence having the first correlation energy equal to 25.

The third calculating means 21 calculates the maximum possible correlation energy $E_{max,end}^{M-M_{RS}}$, represented on the figure 6, from the remaining M-$M_{RS}$ digital data of the received sequence $r_0r_1...r_{M-1}$, with the relation:

$$E_{max,end}^{M-M_{RS}} = \sum_{i=M_{RS}}^{M-1}|r_i|$$

which in this example is:

$$E_{max,end}^{M-M_{RS}} = \sum_{i=12}^{17}|r_i|$$
$$= |-3| + |-1| + |2| + |5| + |7| + |-3|$$
$$= 21.$$

Then adding means 22 add, for each reduced reference sequence, its first correlation energy to the calculated maximum possible correlation energy $E_{max,end}^{M-M_{RS}} = 21$, to obtain a second correlation energy for each reduced reference sequence, this calculate not being necessary for the reduced reference sequence having its first correlation energy equal to the threshold 25.

In this example respective second correlation energies calculated are 8+21=29, 25+21=46, 2+21=23, 18+21=39, and 6+21= 27.

So, the comparing means 23 compare each second correlation energy with said threshold, and first selecting means 24 select as candidate the reduced sequences having their second correlation energy superior to said threshold.

So, in this case, the first reduced sequence, having a second correlation energy equal to 29, the reduced sequence having a first correlation energy equal to $E_{max,beginning}^{M_{RS}} = 25$, and the two reduced sequences having a second correlation energy equal to 39 and to 27, are candidate reduced sequences.

Then making up means 16 complete the candidate sequences, like above described, to obtain complete candidate sequences of M digital data. In the case of convolutional code, a candidate sequence can be completed in several complete candidate sequences.

Then for each complete candidate sequence, a complete correlation energy is calculated by the fourth calculating means 27.

In this example, the above reduced sequence :

$s_0$=1; $s_1$=1; $s_2$=-1; $s_3$=-1; $s_4$=1; $s_5$=1; $s_6$=1; $s_7$=1; $s_8$=1, $s_9$=-1; $s_{10}$=-1; $s_{11}$=1; is selected as a candidate and is for example made up with :

$s_{12}$=-1; $s_{13}$=1; $s_{14}$=-1; $s_{15}$=1; $s_{16}$=1; $s_{17}$=1.

Its complete correlation energy is then calculated with the relation:

$$\sum_{i=0}^{M-1}r_is_i = \sum_{i=0}^{17}r_is_i$$
$$= r_0.s_0 + r_1.s_1 + ... + r_{17}.s_{17}$$
$$= (-1)\times(-2)+(-1)\times(1)+(1)\times(-2)+(1)\times(-4)+(-1)\times(7)+(-1)\times(-3)$$
$$+(-1)\times(-2)+(-1)\times(-1)+(-1)\times(-2)+(1)\times(5)+(1)\times(4)+(-1)\times(-3)$$
$$+(-1)\times(-3)+(1)\times(-1)+(-1)\times(2)+(1)\times(5)+(1)\times(7)+(1)\times(-3)$$
$$= 2-1-2-4-7+3+2+1+2+5+4+3+3-1-2+5+7-3$$
$$= 17$$

This complete correlation energy is equal to the first correlation energy added with the correlation energy or the corresponding end of sequences. So the first correlation energy of candidates sequence can be stored to simplify calculating of complete correlation energies.

Then, among all the complete candidates sequences, the second selecting means 28 select a complete candidate sequence having the highest correlation energy, and the demapping means 29 determine the corresponding sequence of $\hat{x}_0 \hat{x}_1 ... \hat{x}_{N-1}$ N bits from the selected complete candidate sequence.

Furthermore, it is possible to directly store the bits instead of symbols, because in BPSK the mapping is $0 \rightarrow 1$ and $1 \rightarrow -1$, or $0 \rightarrow -1$ and $1 \rightarrow 1$, but in the computations it is necessary to use the corresponding digital data, to use the operator "multiplication" instead of "exclusive or".

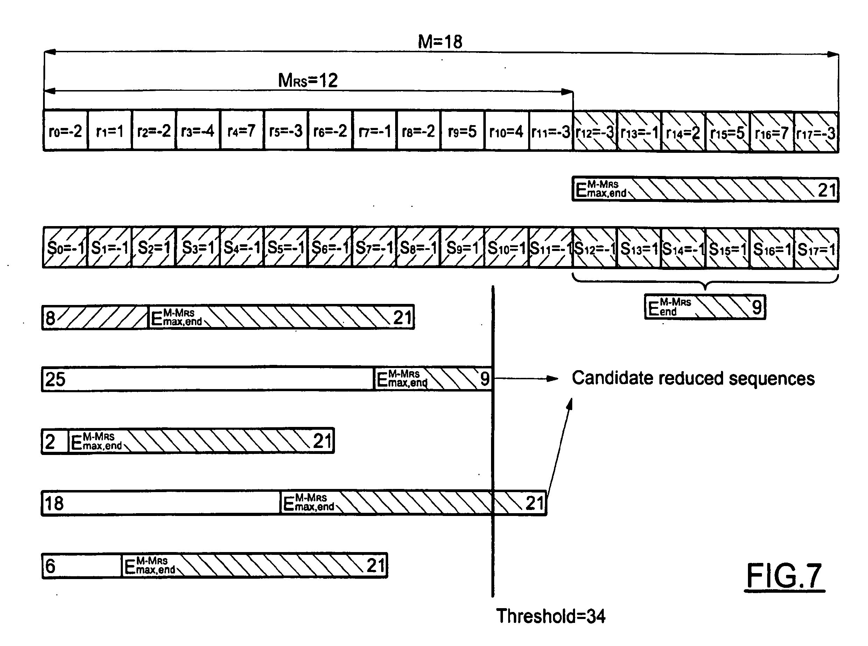

We will illustrate the method with a second concrete case, referring to the figure 7, with a simple modulation scheme BPSK. Of course other modulation schemes are possible.

This case is similar to the precedent case illustrated by the figure 6, but the determining of the threshold is different.

The calculating means 19 determine the maximum $E_{max,beginning}^{M_{RS}}$ of all the calculated first correlation energies, here $E_{max,beginning}^{M_{RS}} = 25$, and for the reduced reference sequence having the first correlation energy equal to 25, which is obtained from the reference digital data corresponding to $N_{RS}$ bits, for example $x_0=1$, $x_1=0$, $x_2=1$, $x_3=0$ the calculating means 19 are then made up this reduced reference sequence, according to the $N-N_{RS}$ remaining bits, for example $x_4=1$, $x_5=1$, which correspond for example to the following $s_{12}=-1$; $s_{13}=1$; $s_{14}=-1$; $s_{15}=1$; $s_{16}=1$; $s_{17}=1$.

For a block code, only one making up is possible, but in case of a convolutional code several making up can be generated. Obviously, for a convolutional code, any one of the possible remaining $M-M_{RS}$ reference digital data $s_{12}$ $s_{13}$ $s_{14}$ $s_{15}$ $s_{16}$ $s_{17}$ can be used for the computation of the threshold.

So the calculating means 19 calculate the correlation energy $E_{end}^{M-M_{RS}}$ from the remaining $M-M_{RS}$ digital data of the received sequence $r_0 r_1 ... r_{M-1}$ and the remaining $M-M_{RS}$ digital data of said made up reduced reference sequence, which is, in this case equal to

$$
\sum_{i=M_{RS}}^{M-1} r_i s_i = \sum_{i=12}^{17} r_i s_i
$$
$$
= (-1) \times (-3) + (1) \times (-1) + (-1) \times (2) + (1) \times (5) + (1) \times (7) + (1) \times (-3)
$$
$$
= 3 - 1 - 2 + 5 + 7 - 3
$$
$$
= 9
$$

Then the calculating means 19 calculate the threshold as being the sum of the maximum $E_{max,beginning}^{M_{RS}}$ and the correlation energy $E_{end}^{M-M_{RS}}$. This threshold is equal here to 25+9=34.

Nevertheless, an optimal method for a convolutional code is to calculate the correlation energy $E_{end}^{M-M_{RS}}$ from the $2^{N-N_{RS}}$ remaining $M-M_{RS}$ digital data for each possible remaining $M-M_{RS}$ digital data generated, and choose the maximum correlation energy. On the one hand, computation is more complex, but on the other hand, less candidate sequences are selected, which in turn reduces the overall complexity.

The other steps of the method are the same as those described above described, but because the value of the threshold is different (34 instead of 25), less reduced sequences are selected as candidates.

In comparison, with this threshold equal to 34, only two sequences are selected as candidates, whereas in the precedent case where the threshold is equal to 25, four sequences are selected as candidates.

In this case the determining of the threshold is longer, but candidates sequences are less numerous, so the rest of the method is more quick.

The invention allows an optimal decoding algorithm, with a decrease of memory size used and computations made.

**EP 1 564 894 B1**

**Claims**

1. Method for estimating a sequence of N bits $(\hat{x}_0\hat{x}_1...\hat{x}_{N-1})$ corresponding to a received sequence of M digital data $(r_0r_1...r_{M-1})$, comprising the steps of :

   a) determining (31) candidate sequences of $M_{RS}$ digital data from a reduced reference sequence space comprising $2^{N_{RS}}$ reduced reference sequences of $M_{RS}$ reference digital data $(s_0s_1...s_{M_{RS}-1})$, $M_{RS}$ being inferior to M and $2^{N_{RS}}$ being inferior or equal to $2^N$;
   b) making up (32) each candidate sequence with remaining reference digital data to obtain at least one complete candidate sequence of M digital data ; and
   c) determining (33) said sequence of N bits $(\hat{x}_0\hat{x}_1...\hat{x}_{N-1})$ from all the complete candidate sequences, wherein said determining step a) (31) comprises:

      - calculating for each reduced reference sequence a first correlation energy from said reduced reference sequence and the $M_{RS}$ first digital data of the received sequence $(r_0r_1...r_{M_{RS}-1})$;
      - determining a threshold as being the maximum of all the calculated first correlation energies ; and
      - taking into account said threshold for determining said candidate sequences.

2. Method for estimating a sequence of N bits $(\hat{x}_0\hat{x}_1...\hat{x}_{N-1})$ corresponding to a received sequence of M digital data $(r_0r_1...r_{M-1})$, comprising the steps of:

   a) determining (31) candidate sequences of $M_{RS}$ digital data from a reduced reference sequence space comprising $2^{N_{RS}}$ reduced reference sequences of $M_{RS}$ reference digital data $(s_0s_1...s_{M_{RS}-1})$, $M_{RS}$ being inferior to M and $2^{N_{RS}}$ being inferior or equal to $2^N$ ;
   b) making up (32) each candidate sequence with remaining reference digital data to obtain at least one complete candidate sequence of M digital data; and
   c) determining (33) said sequence of N bits $(\hat{x}_0\hat{x}_1...\hat{x}_{N-1})$ from all the complete candidate sequences, wherein said determining step a) (31) comprises:

      - calculating for each reduced reference sequence a first correlation energy from said reduced reference sequence and the $M_{RS}$ first digital data of the received sequence $(r_0r_1...r_{M_{RS}-1})$;
      - determining the maximum of all the calculated first correlation energies;
      - making up the reduced reference sequence having said maximum of all the calculated first correlation energies, with a set of corresponding remaining reference digital data to obtain a complete reference sequence;

      - calculating a correlation energy $\left(E_{end}^{M-M_{RS}}\right)$ from the remaining $M-M_{RS}$ digital data of received sequence $(r_{M_{RS}}, r_{M_{RS}+1}...r_{M-1})$ and the remaining $M-M_{RS}$ digital data of said made up reduced reference sequence; and

      - adding said maximum of all the calculated first correlation energies and said calculated correlation energy $\left(E_{end}^{M-M_{RS}}\right)$, in order to obtain a threshold;
      - taking into account said threshold for determining said candidate sequences.

3. Method according to claim 1 or 2, **characterized by** the fact that said determining step a) (31) comprises:

      - calculating the maximum possible correlation energy $\left(E_{max,end}^{M-M_{RS}}\right)$ from the remaining $M-M_{RS}$ digital data of the received sequence $(r_{M_{RS}}, r_{M_{RS}+1}...r_{M-1})$;
      - for each reduced reference sequence, adding its first correlation energy to said calculated maximum possible correlation energy $\left(E_{max,end}^{M-M_{RS}}\right)$ to obtain a second correlation energy ;

- comparing each second correlation energy with said threshold; and
- selecting as candidates the reduced sequences having their second correlation energy superior to said threshold.

4. Method according to any one of claim 1 to 3, **characterized by** the fact that said making up step b) (32) comprises, for each candidate sequence, reading a predetermined set of stored possible $M-M_{RS}$ remaining reference digital data, to obtain a complete candidate sequence of M digital data.

5. Method according to any one of claim 1 to 4, **characterized by** the fact that said making up step b) (32) comprises, for each candidate sequence, generating a set of possible $M-M_{RS}$ remaining reference digital data, to obtain a complete candidate sequence of M digital data.

6. Method according to any one of claim 1 to 5, **characterized by** the fact that said determining step c) (33) comprises :

   - calculating for each complete candidate sequence a complete correlation energy from said complete candidate sequence and the received sequence ($r_0 r_1 ... r_{M-1}$);
   - selecting a complete candidate sequence having the highest complete correlation energy ; and
   - determining said sequence of N bits ($\hat{x}_0 \hat{x}_1 ... \hat{x}_{N-1}$) from said selected complete candidate sequence.

7. System (1) for estimating a sequence of N bits ($\hat{x}_0 \hat{x}_1 ... \hat{x}_{N-1}$) corresponding to a received sequence of M digital data ($r_0 r_1 ... r_{M-1}$), comprising:

   - first determining means (15) for determining candidate sequences of $M_{RS}$ digital data from a reduced reference sequence space comprising $2^{N_{RS}}$ reduced reference sequences of $M_{RS}$ reference digital data ($s_0 r_1 ... s_{M_{RS}-1}$), $M_{RS}$ being inferior to M and $2^{N_{RS}}$ being inferior or equal to $2^N$ ;
   - making up means (16) for making up each candidate sequence with remaining reference digital data to obtain at least one complete candidate sequence of M digital data; and
   - second determining means (17) for determining said sequence of N bits ($\hat{x}_0 \hat{x}_1 ... \hat{x}_{N-1}$) from all the complete candidate sequences, wherein said first determining means (15) comprise :
   - first calculating means (18) for calculating for each reduced reference sequence a first correlation energy from said reduced reference sequence and the $M_{RS}$ first digital data of the received sequence ($r_0 r_1 ... r_{M_{RS}-1}$);
   - second calculating means (19) for determining a threshold as being the maximum of all the calculated first correlation energies ; and
   - processing means (20) for determining said candidate sequences, taking into account said threshold.

8. System (1) for estimating a sequence of N bits ($\hat{x}_0 \hat{x}_1 ... \hat{x}_{N-1}$) corresponding to a received sequence of M digital data ($r_0 r_1 ... r_{M-1}$), comprising:

   - first determining means (15) for determining candidate sequences of $M_{RS}$ digital data from a reduced reference sequence space comprising $2^{N_{RS}}$ reduced reference sequences of $M_{RS}$ reference digital data ($s_0 s_1 ... s_{M_{RS}-1}$), $M_{RS}$ being inferior to M and $2^{N_{RS}}$ being inferior or equal to $2^N$ ;
   - making up means (16) for making up each candidate sequence with remaining reference digital data to obtain at least one complete candidate sequence of M digital data ; and
   - second determining means (17) for determining said sequence of N bits ($\hat{x}_0 \hat{x}_1 ... \hat{x}_{N-1}$) from all the complete candidate sequences, wherein said first determining means (15) comprise:
   - first calculating means (18) for calculating for each reduced reference sequence a first correlation energy from said reduced reference sequence and the $M_{RS}$ first digital data of the received sequence ($r_0 r_1 ... r_{M_{RS}-1}$) ;

   second calculating means (19) adapted for:

   ■ determining the maximum of all the calculated first correlation energies;
   ■ making up the reduced reference sequence having said maximum of all the calculated first correlation energies, with a set of corresponding remaining reference digital data to obtain a complete reference sequence;

   ■ calculating a correlation energy ($E_{end}^{M-M_{RS}}$) from the remaining M-MRS digital data of the received sequences ($r_{M_{RS}}, r_{M_{RS}+1} ... r_{M-1}$) and the remaining $M-M_{RS}$ digital data of said made up reduced reference sequence;

■ adding said maximum of all the calculated first correlation energies and said calculated correlation energy

$(\ E_{end}^{M-M_{RS}}\ )$ in order to obtain a threshold; and

- processing means (20) for determining said candidate sequences, taking into account said threshold.

9. System according to claim 7 or 8, **characterized by** the fact that said first determining means (15) comprise:

- third calculating means (21) for calculating the maximum possible correlation energy $\left(E_{max,end}^{M-M_{RS}}\right)$ from the remaining M-M$_{RS}$ digital data of the received sequence ($r_{M_{RS}}$, $r_{M_{RS}+1}$...$r_{M-1}$);
- adding means (22) for adding, for each reduced reference sequence, its first correlation energy to said calculated maximum possible correlation energy $(\ E_{max,end}^{M-M_{RS}}\ )$, to obtain a second correlation energy ;

and by the fact that said processing means (20) comprise:
- comparing means (23) for comparing each second correlation energy with said threshold; and
- first selecting means (24) for selecting as candidates the reduced sequences having their second correlation energy superior to said threshold.

10. System according to any one of claims 7 to 9, **characterized by** the fact that said making up means (16) comprise a memory (25) for storing predetermined possible M-M$_{RS}$ remaining reference digital data, and reading means (26) for reading, for each candidate sequence, said stored predetermined possible M-M$_{RS}$ remaining reference digital data, to obtain a complete candidate sequence of M digital data.

11. System according to any one of claims 7 to 10, **characterized by** the fact that said making up means (16) comprise generating means (30) for generating, for each candidate sequence, a set of possible M-M$_{RS}$ remaining reference digital data, to obtain a compete candidate sequence of M digital data.

12. System according to any one of claims 7 to 11, **characterized by** the fact that said second determining means (17) comprise:

- fourth calculating means (27) for calculating, for each complete candidate sequence, a complete correlation energy from said complete candidate sequence and the received sequence ($r_0 r_1$...$r_{M-1}$);
- second selecting means (28) for selecting a complete candidate sequence having the highest complete correlation energy; and
- demapping means (29) for determining the corresponding sequence of N bits ($\hat{x}_0 \hat{x}_1$...$\hat{x}_{N-1}$) from said selected complete candidate sequence.

13. Receiving apparatus, in particular a cellular mobile phone (TP), **characterized by** the fact that it incorporates a system as defined in any one of claims 7 to 12.

**Patentansprüche**

1. Verfahren zur Schätzung einer Sequenz von N Bit ($\hat{x}_0 \hat{x}_1$...$\hat{x}_{N-1}$), die einer empfangenen Sequenz von M Digitaldaten ($r_0 r_1$...$r_{M-1}$) entspricht, mit den folgenden Schritten:

a) Bestimmen (31) von in Frage kommenden Sequenzen von M$_{RS}$ Digitaldaten aus einem Raum reduzierter Referenzsequenzen, der $2^{N_{RS}}$ reduzierte Referenzsequenzen von M$_{RS}$ Referenz-Digitaldaten ($s_0 s_1$...$s_{M_{RS}-1}$) umfasst, wobei M$_{RS}$ kleiner als M und $2^{N_{RS}}$ kleiner oder gleich $2^N$ ist;
b) Vervollständigen (32) jeder in Frage kommenden Sequenz mit übrigen Referenz-Digitaldaten, um mindestens eine vollständige in Frage kommende Sequenz von M Digitaldaten zu erhalten; und
c) Bestimmen (33) der Sequenz von N Bit ($\hat{x}_0 \hat{x}_1$...$\hat{x}_{N-1}$) aus allen vollständigen in Frage kommenden Sequenzen, wobei der Bestimmungsschritt a) (31) Folgendes umfasst:

- Berechnen einer ersten Korrelationsenergie für jede reduzierte Referenzsequenz aus der reduzierten Referenzsequenz und den M$_{RS}$ ersten Digitaldaten der empfangenen Sequenz ($r_0 r_1$...$r_{M_{RS}-1}$);
- Bestimmen einer Schwelle als das Maximum aller berechneten ersten Korrelationsenergien; und

- Berücksichtigen der Schwelle zur Bestimmung der in Frage kommenden Sequenzen.

2. Verfahren zur Schätzung einer Sequenz von N Bit $(\hat{x}_0\hat{x}_1...\hat{x}_{N-1})$, die einer empfangenen Sequenz von M Digitaldaten $(r_0r_1...r_{M-1})$ entspricht, mit den folgenden Schritten:

a) Bestimmen (31) von in Frage kommenden Sequenzen von $M_{RS}$ Digitaldaten aus einem Raum reduzierter Referenzsequenzen, der $2^{N_{RS}}$ reduzierte Referenzsequenzen von $M_{RS}$ Referenz-Digitaldaten $(s_0s_1...s_{M_{RS}-1})$ umfasst, wobei $M_{RS}$ kleiner als M und $2^{N_{RS}}$ kleiner oder gleich $2^N$ ist;
b) Vervollständigen (32) jeder in Frage kommenden Sequenz mit übrigen Referenz-Digitaldaten, um mindestens eine vollständige in Frage kommende Sequenz von M Digitaldaten zu erhalten; und
c) Bestimmen (33) der Sequenz von N Bit $(\hat{x}_0\hat{x}_1...\hat{x}_{N-1})$ aus allen vollständigen in Frage kommenden Sequenzen, wobei der Bestimmungsschritt a) (31) Folgendes umfasst:

- Berechnen einer ersten Korrelationsenergie für jede reduzierte Referenzsequenz aus der reduzierten Referenzsequenz und den $M_{RS}$ ersten Digitaldaten der empfangenen Sequenz $(r_0r_1...r_{M_{RS}-1})$;
- Bestimmen des Maximums aller berechneten ersten Korrelationsenergien;
- Vervollständigen der reduzierten Referenzsequenz, die das Maximum aller berechneten ersten Korrelationsenergien aufweist, mit einer Menge von entsprechenden übrigen Referenz-Digitaldaten, um eine vollständige Referenzsequenz zu erhalten;

- Berechnen einer Korrelationsenergie ($E_{end}^{M-M_{RS}}$) aus den übrigen M-$M_{RS}$-Digitaldaten der empfangenen Sequenz $(r_{M_{RS}},r_{M_{RS}+1}...r_{M-1})$ und den übrigen M-$M_{RS}$-Digitaldaten der vervollständigten reduzierten Referenzsequenz;.und

- Addieren des Maximums aller berechneten ersten Korrelationsenergien und der berechneten Korrelationsenergie ($E_{end}^{M-M_{RS}}$), um eine Schwelle zu erhalten;
- Berücksichtigen der Schwelle zur Bestimmung der in Frage kommenden Sequenzen.

3. Verfahren nach Anspruch 1 oder 2, **gekennzeichnet durch** den Umstand, dass der Bestimmungsschritt a) (31) Folgendes umfasst:

- Berechnen der maximal möglichen Korrelationsenergie ($E_{max,end}^{M-M_{RS}}$) aus den übrigen M-$M_{RS}$-Digitaldaten der empfangenen Sequenz $(r_{M_{RS}},r_{M_{RS}+1}...r_{M-1})$;
- für jede reduzierte Referenzsequenz Addieren ihrer ersten Korrelationsenergie zu der berechneten maximal möglichen Korrelationsenergie ($E_{max,end}^{M-M_{RS}}$), um eine zweite Korrelationsenergie zu erhalten;
- Vergleichen jeder zweiten Korrelationsenergie mit der Schwelle; und
- Auswählen als in Frage kommend der reduzierten Sequenzen, deren zweite Korrelationsenergie größer als die Schwelle ist.

4. Verfahren nach einem der Ansprüche 1 bis 3, **gekennzeichnet durch** den Umstand, dass der Vervollständigungsschritt b) (32) Folgendes umfasst: für jede in Frage kommende Sequenz Lesen einer vorbestimmten Menge von gespeicherten möglichen $MM_{RS}$ übrigen Referenz-Digitaldaten, um eine vollständige in Frage kommende Sequenz von M Digitaldaten zu erhalten.

5. Verfahren nach einem der Ansprüche 1 bis 4, **gekennzeichnet durch** den Umstand, dass der Vervollständigungsschritt b) (32) Folgendes umfasst: für jede in Frage kommende Sequenz Erzeugen einer Menge von möglichen M-$M_{RS}$ übrigen Referenz-Digitaldaten, um eine vollständige in Frage kommende Sequenz von M Digitaldaten zu erhalten.

6. Verfahren nach einem der Ansprüche 1 bis 5, **gekennzeichnet durch** den Umstand, dass der Bestimmungsschritt c) (33) Folgendes umfasst:

- Berechnen einer vollständigen Korrelationsenergie für jede vollständige in Frage kommende Sequenz aus der vollständigen in Frage kommenden Sequenz und der empfangenen Sequenz $(r_0r_1...r_{M-1})$;
- Auswählen einer vollständigen in Frage kommenden Sequenz, die die höchste vollständige Korrelationsenergie aufweist; und

- Bestimmen der Sequenz von N Bit $(\hat{x}_0\hat{x}_1...\hat{x}_{N-1})$ aus der gewählten vollständigen in Frage kommenden Sequenz.

**7.** System (1) zur Schätzung einer Sequenz von N Bit $(\hat{x}_0\hat{x}_1...\hat{x}_{N-1})$, die einer empfangenen Sequenz von M Digitaldaten $(r_0r_1...r_{M-1})$ entspricht, umfassend:

- ein erstes Bestimmungsmittel (15) zum Bestimmen von in Frage kommenden Sequenzen von $M_{RS}$ Digitaldaten aus einem Raum reduzierter Referenzsequenzen, der $2^{N_{RS}}$ reduzierte Referenzsequenzen von $M_{RS}$ Referenz-Digitaldaten $(s_0s_1...s_{M_{RS}-1})$ umfasst, wobei $M_{RS}$ kleiner als M und $2^{N_{RS}}$ kleiner oder gleich $2^N$ ist;
- ein Vervollständigungsmittel (16) zum Vervollständigen jeder in Frage kommenden Sequenz mit übrigen Referenz-Digitaldaten, um mindestens eine vollständige in Frage kommende Sequenz von M Digitaldaten zu erhalten; und
- ein zweites Bestimmungsmittel (17) zum Bestimmen der Sequenz von N Bit $(\hat{x}_0\hat{x}_1...\hat{x}_{N-1})$ aus allen vollständigen in Frage kommenden Sequenzen, wobei das erste Bestimmungsmittel (15) Folgendes umfasst:
- ein erstes Berechnungsmittel (18) zum Berechnen einer ersten Korrelationsenergie für jede reduzierte Referenzsequenz aus der reduzierten Referenzsequenz und den $M_{RS}$ ersten Digitaldaten der empfangenen Sequenz $(r_0r_1...r_{M_{RS}-1})$;
- ein zweites Berechnungsmittel (19) zum Bestimmen einer Schwelle als das Maximum aller berechneten ersten Korrelationsenergien; und
- ein Verarbeitungsmittel (20) zum Bestimmen der in Frage kommenden Sequenzen unter Berücksichtigung der Schwelle.

**8.** System (1) zur Schätzung einer Sequenz von N Bit $(\hat{x}_0\hat{x}_1...\hat{x}_{N-1})$, die einer empfangenen Sequenz von M Digitaldaten $(r_0r_1...r_{M-1})$ entspricht, umfassend:

- ein erstes Bestimmungsmittel (15) zum Bestimmen von in Frage kommenden Sequenzen von $M_{RS}$ Digitaldaten aus einem Raum reduzierter Referenzsequenzen, der $2^{N_{RS}}$ reduzierte Referenzsequenzen von $M_{RS}$ Referenz-Digitaldaten $(s_0s_1...s_{M_{RS}-1})$ umfasst, wobei $M_{RS}$ kleiner als Mund $2^{N_{RS}}$ kleiner oder gleich $2^N$ ist;
- ein Vervollständigungsmittel (16) zum Vervollständigen jeder in Frage kommenden Sequenz mit übrigen Referenz-Digitaldaten, um mindestens eine vollständige in Frage kommende Sequenz von M Digitaldaten zu erhalten; und
- ein zweites Bestimmungsmittel (17) zum Bestimmen der Sequenz von N Bit $(\hat{x}_0\hat{x}_1...\hat{x}_{N-1})$ aus allen vollständigen in Frage kommenden Sequenzen, wobei das erste Bestimmungsmittel (15) Folgendes umfasst:
- ein erstes Berechnungsmittel (18) zum Berechnen einer ersten Korrelationsenergie für jede reduzierte Referenzsequenz aus der reduzierten Referenzsequenz und den $M_{RS}$ ersten Digitaldaten der empfangenen Sequenz $(r_0r_1...r_{M_{RS}-1})$;
- ein zweites Berechnungsmittel (19), das für Folgendes ausgelegt ist:

■ Bestimmen des Maximums aller berechneten ersten Korrelationsenergien;
■ Vervollständigen der reduzierten Referenzsequenz, die das Maximum aller berechneten ersten Korrelationsenergien aufweist, mit einer Menge von entsprechenden übrigen Referenz-Digitaldaten, um eine vollständige Referenzsequenz zu erhalten;

■ Berechnen einer Korrelationsenergie ($E_{end}^{M-M_{RS}}$) aus den übrigen M-$M_{RS}$-Digitaldaten der empfangenen Sequenz ($r_{M_{RS}},r_{M_{RS}+1}...r_{M-1}$) und den übrigen M-$M_{RS}$-Digitaldaten der vervollständigten reduzierten Referenzsequenz;

■ Addieren des Maximums aller berechneten ersten Korrelationsenergien und der berechneten Korrelationsenergie ($E_{end}^{M-M_{RS}}$), um eine Schwelle zu erhalten; und

- ein Verarbeitungsmittel (20) zum Bestimmen der in Frage kommenden Sequenzen unter Berücksichtigung der Schwelle.

**9.** System nach Anspruch 7 oder 8, **gekennzeichnet durch** den Umstand, dass das erste Bestimmungsmittel (15) Folgendes umfasst:

- ein drittes Berechnungsmittel (21) zum Berechnen der maximal möglichen Korrelationsenergie ($E_{max,end}^{M-M_{RS}}$) aus den übrigen M-$M_{RS}$-Digitaldaten der empfangenen Sequenz ($r_{M_{RS}}, r_{M_{RS}+1}...r_{M-1}$) ;

- ein Addiermittel (22) zum Addieren, für jede reduzierte Referenzsequenz, ihrer ersten Korrelationsenergie zu der berechneten maximal möglichen Korrelationsenergie ($E_{max,end}^{M-M_{RS}}$) , um eine zweite Korrelationsenergie zu erhalten;

und **durch** den Umstand, dass das Verarbeitungsmittel (20) Folgendes umfasst:

- ein Vergleichsmittel (23) zum Vergleichen jeder zweiten Korrelationsenergie mit der Schwelle; und
- ein erstes Auswahlmittel (24) zum Auswählen als in Frage kommend der reduzierten Sequenzen, deren zweite Korrelationsenergie größer als die Schwelle ist.

10. System nach einem der Ansprüche 7 bis 9, **gekennzeichnet durch** den Umstand, dass das Vervollständigungsmittel (16) Folgendes umfasst: einen Speicher (25) zum Speichern von vorbestimmten möglichen M-$M_{RS}$ übrigen Referenz-Digitaldaten und ein Lesemittel (26) zum Lesen der gespeicherten vorbestimmten möglichen M-$M_{RS}$ übrigen Referenz-Digitaldaten für jede in Frage kommende Sequenz, um eine vollständige in Frage kommende Sequenz von M Digitaldaten zu erhalten.

11. System nach einem der Ansprüche 7 bis 10, **gekennzeichnet durch** den Umstand, dass das Vervollständigungsmittel (16) Folgendes umfasst: ein Erzeugungsmittel (30) zum Erzeugen einer Menge von möglichen M-$M_{RS}$ übrigen Referenz-Digitaldaten für jede in Frage kommende Sequenz, um eine vollständige in Frage kommende Sequenz von M Digitaldaten zu erhalten.

12. System nach einem der Ansprüche 7 bis 11, **gekennzeichnet durch** den Umstand, dass das zweite Bestimmungsmittel (17) Folgendes umfasst:

- ein viertes Berechnungsmittel (27) zum Berechnen einer vollständigen Korrelationsenergie für jede vollständige in Frage kommende Sequenz aus der vollständigen in Frage kommenden Sequenz und der empfangenen Sequenz ($r_0 r_1...r_{M-1}$);
- ein zweites Auswahlmittel (28) zum Auswählen einer vollständigen in Frage kommenden Sequenz, die die höchste vollständige Korrelationsenergie aufweist; und
- ein Demapping-Mittel (29) zum Bestimmen der entsprechenden Sequenz von N Bit ($\hat{x}_0 \hat{x}_1...\hat{x}_{N-1}$) aus der gewählten vollständigen in Frage kommenden Sequenz.

13. Empfangsvorrichtung, insbesondere ein zellulares Mobiltelefon (TP), **gekennzeichnet durch** den Umstand, dass es ein System nach einem der Ansprüche 7 bis 12 umfasst.

**Revendications**

1. Procédé d'estimation d'une séquence de N bits ($\hat{x}_0 \hat{x}_1...\hat{x}_{N-1}$) correspondant à une séquence reçue de M données numériques ($r_0 r_1...r_{M-1}$), comprenant les étapes consistant à :

a) déterminer (31) des séquences candidates de $M_{RS}$ données numériques à partir d'un espace de séquences de référence réduites comprenant $2^{N_{RS}}$ séquences de référence réduites de $M_{RS}$ données numériques de référence ($s_0 s_1...s_{M_{RS}-1}$), $M_{RS}$ étant inférieur à M et $2^{N_{RS}}$ étant inférieur ou égal à $2^N$;
b) compléter (32) chaque séquence candidate par des données numériques de référence restantes afin d'obtenir au moins une séquence candidate complète de M données numériques ; et
c) déterminer (33) ladite séquence de N bits ($\hat{x}_0 \hat{x}_1...\hat{x}_{N-1}$) à partir de toutes les séquences candidates complètes, dans lequel ladite étape de détermination a) (31) consiste à :

- calculer, pour chaque séquence de référence réduite, une première énergie de corrélation à partir de ladite séquence de référence réduite et des $M_{RS}$ premières données numériques de la séquence reçue ($r_0 r_1...r_{M_{RS}-1}$) ;
- déterminer en tant que seuil le maximum de toutes les premières énergies de corrélation calculées ; et
- prendre en compte ledit seuil pour déterminer lesdites séquences candidates.

**2.** Procédé d'estimation d'une séquence de N bits **$(\hat{x}_0\hat{x}_1...\hat{x}_{N-1})$** correspondant à une séquence reçue de M données numériques $(r_0r_1...r_{M-1})$, comprenant les étapes consistant à :

    a) déterminer (31) des séquences candidates de $M_{RS}$ données numériques à partir d'un espace de séquences de référence réduites comprenant $2^{N_{RS}}$ séquences de référence réduites de $M_{RS}$ données numériques de référence $(s_0s_1...s_{M_{RS}-1})$, $M_{RS}$ étant inférieur à M et $2^{N_{RS}}$ étant inférieur ou égal à $2^N$ ;
    b) compléter (32) chaque séquence candidate par des données numériques de référence restantes afin d'obtenir au moins une séquence candidate complète de M données numériques ; et
    c) déterminer (33) ladite séquence de N bits **$(\hat{x}_0\hat{x}_1...\hat{x}_{N-1})$** à partir de toutes les séquences candidates complètes, dans lequel ladite étape de détermination a) (31) consiste à :

    - calculer, pour chaque séquence de référence réduite, une première énergie de corrélation à partir de ladite séquence de référence réduite et des $M_{RS}$ premières données numériques de la séquence reçue $(r_0r_1...r_{M_{RS}-1})$ ;
    - déterminer le maximum de toutes les premières énergies de corrélation calculées ;
    - compléter la séquence de référence réduite ayant ledit maximum de toutes les premières énergies de corrélation calculées, par un ensemble de données numériques de référence restantes correspondantes afin d'obtenir une séquence de référence complète ;

    - calculer une énergie de corrélation ( $E_{end}^{M-M_{RS}}$ ) à partir des $M-M_{RS}$ données numériques restantes de la séquence reçue $(r_{M_{RS}},r_{M_{RS}+1}...r_{M-1})$ et des $M-M_{RS}$ données numériques restantes de ladite séquence de référence réduite complétée ; et
    - additionner ledit maximum de toutes les premières énergies de corrélation calculées et ladite énergie de corrélation calculée ( $E_{end}^{M-M_{RS}}$ ) afin d'obtenir un seuil ;
    - prendre en compte ledit seuil pour déterminer lesdites séquences candidates.

**3.** Procédé selon la revendication 1 ou 2, **caractérisé par le fait que** ladite étape de détermination a) (31) consiste à :

    - calculer l'énergie de corrélation maximale possible ( $E_{\max,end}^{M-M_{RS}}$ ) à partir des $M-M_{RS}$ données numériques restantes de la séquence reçue $(r_{M_{RS}},r_{M_{RS}-1}...r_{M-1})$ ;
    - pour chaque séquence de référence réduite, additionner sa première énergie de corrélation à ladite énergie de corrélation maximale possible calculée ( $E_{\max,end}^{M-M_{RS}}$ ) afin d'obtenir une seconde énergie de corrélation ;
    - comparer chaque seconde énergie de corrélation audit seuil ; et
    - sélectionner en tant que candidates les séquences réduites dont la seconde énergie de corrélation est supérieure audit seuil.

**4.** Procédé selon l'une quelconque des revendications 1 à 3, **caractérisé par le fait que** ladite étape de complétion b) (32) consiste, pour chaque séquence candidate, à lire un ensemble prédéterminé de $M-M_{RS}$ données numériques de référence restantes possibles stockées afin d'obtenir une séquence candidate complète de M données numériques.

**5.** Procédé selon l'une quelconque des revendications 1 à 4, **caractérisé par le fait que** ladite étape de complétion b) (32) consiste, pour chaque séquence candidate, à générer un ensemble de $M-M_{RS}$ données numériques de référence restantes possibles, afin d'obtenir une séquence candidate complète de M données numériques.

**6.** Procédé selon l'une quelconque des revendications 1 à 5, **caractérisé par le fait que** ladite étape de détermination c) (33) consiste à :

    - calculer, pour chaque séquence candidate complète, une énergie de corrélation complète à partir de ladite séquence candidate complète et de la séquence reçue $(r_0r_1...r_{M-1})$ ;
    - sélectionner une séquence candidate complète ayant l'énergie de corrélation complète la plus élevée ; et
    - déterminer ladite séquence de N bits $(\hat{x}_0\hat{x}_1...\hat{x}_{N-1})$ à partir de ladite séquence candidate complète sélectionnée.

**7.** Système (1) d'estimation d'une séquence de N bits $(\hat{x}_0\hat{x}_1...\hat{x}_{N-1})$ correspondant à une séquence reçue de M données

numériques ($r_0r_1...r_{M-1}$), comprenant :

- des premiers moyens de détermination (15) destinés à déterminer des séquences candidates de $M_{RS}$ données numériques à partir d'un espace de séquences de référence réduites comprenant $2^{N_{RS}}$ séquences de référence réduites de $M_{RS}$ données numériques de référence ($s_0s_1...s_{M_{RS}-1}$), $M_{RS}$ étant inférieur à M et $2^{N_{RS}}$ étant inférieur ou égal à $2^N$ ;
- des moyens de complétion (16) destinés à compléter chaque séquence candidate par des données numériques de référence restantes afin d'obtenir au moins une séquence candidate complète de M données numériques ; et
- des seconds moyens de détermination (17) destinés à déterminer ladite séquence de N bits ($\hat{x}_0\hat{x}_1...\hat{x}_{N-1}$) à partir de toutes les séquences candidates complètes, dans lequel lesdits premiers moyens de détermination (15) comprennent :
- des premiers moyens de calcul (18) destinés à calculer, pour chaque séquence de référence réduite, une première énergie de corrélation à partir de ladite séquence de référence réduite et des $M_{RS}$ premières données numériques de la séquence reçue ($r_0r_1...r_{M_{RS}-1}$) ;
- des seconds moyens de calcul (19) destinés à déterminer en tant que seuil le maximum de toutes les premières énergies de corrélation calculées ; et
- des moyens de traitement (20) destinés à déterminer lesdites séquences candidates en tenant compte dudit seuil.

8. Système (1) d'estimation d'une séquence de N bits ($\hat{x}_0\hat{x}_1...\hat{x}_{N-1}$) correspondant à une séquence reçue de M données numériques ($r_0r_1...r_{M-1}$), comprenant :

- des premiers moyens de détermination (15) destinés à déterminer des séquences candidates de $M_{RS}$ données numériques à partir d'un espace de séquences de référence réduites comprenant $2^{N_{RS}}$ séquences de référence réduites de $M_{RS}$ données numériques de référence ($s_0s_1...s_{M_{RS}-1}$), $M_{RS}$ étant inférieur à M et $2^{N_{RS}}$ étant inférieur ou égal à $2^N$;
- des moyens de complétion (16) destinés à compléter chaque séquence candidate par des données numériques de référence restantes afin d'obtenir au moins une séquence candidate complète de M données numériques ; et
- des seconds moyens de détermination (17) destinés à déterminer ladite séquence de N bits ($\hat{x}_0\hat{x}_1...\hat{x}_{N-1}$) à partir de toutes les séquences candidates complètes, dans lequel lesdits premiers moyens de détermination (15) comprennent :
- des premiers moyens de calcul (18) destinés à calculer, pour chaque séquence de référence réduite, une première énergie de corrélation à partir de ladite séquence de référence réduite et des $M_{RS}$ premières données numériques de la séquence reçue ($r_0r_0...r_{M_{RS}-1}$) ;
- des seconds moyens de calcul (19) conçus pour :

■ déterminer le maximum de toutes les premières énergies de corrélation calculées ;
■ compléter la séquence de référence réduite ayant ledit maximum de toutes les premières énergies de corrélation calculées, par un ensemble de données numériques de référence restantes correspondantes afin d'obtenir une séquence de référence complète ;

■ calculer une énergie de corrélation ($E_{end}^{M-M_{RS}}$) à partir des $M-M_{RS}$ données numériques restantes de la séquence reçue ($r_{M_{RS}},r_{M_{RS}+1}...r_{M-1}$) et des $M-M_{RS}$ données numériques restantes de ladite séquence de référence réduite complétée ;
■ additionner ledit maximum de toutes les premières énergies de corrélation calculées et ladite énergie de corrélation calculée ($E_{end}^{M-M_{RS}}$) afin d'obtenir un seuil ; et

- des moyens de traitement (20) destinés à déterminer lesdites séquences candidates en tenant compte dudit seuil.

9. Système selon la revendication 7 ou 8, **caractérisé par le fait que** lesdits premiers moyens de détermination (15) comprennent :

- des troisièmes moyens de calcul (21) destinés à calculer l'énergie de corrélation maximale possible ($E_{\max,end}^{M-M_{RS}}$) à partir des $M-M_{RS}$ données numériques restantes de la séquence reçue ($r_{M_{RS}},r_{M_{RS}+1}...r_{M-1}$) ;

- des moyens d'addition (22) destinés à additionner, pour chaque séquence de référence réduite, sa première énergie de corrélation à ladite énergie de corrélation maximale possible calculée $\left( E_{\max,end}^{M-M_{RS}} \right)$ afin d'obtenir une seconde énergie de corrélation ;

et **par le fait que** lesdits moyens de traitement (20) comprennent :

- des moyens de comparaison (23) destinés à comparer chaque seconde énergie de corrélation audit seuil ; et
- des premiers moyens de sélection (24) destinés à sélectionner en tant que candidates les séquences réduites dont la seconde énergie de corrélation est supérieure audit seuil.

10. Système selon l'une quelconque des revendications 7 à 9, **caractérisé par le fait que** lesdits moyens de complétion (16) comprennent une mémoire (25) destinée à stocker $M-M_{RS}$ données numériques de référence restantes possibles prédéterminées et des moyens de lecture (26) destinés à lire, pour chaque séquence candidate, lesdites $M-M_{RS}$ données numériques de références restantes possibles prédéterminées afin d'obtenir une séquence candidate complète de M données numériques.

11. Système selon l'une quelconque des revendications 7 à 10, **caractérisé par le fait que** lesdits moyens de complétion (16) comprennent des moyens générateurs (30) destinés à générer, pour chaque séquence candidate, un ensemble de $M-M_{RS}$ données numériques de référence restantes possibles afin d'obtenir une séquence candidate complète de M données numériques.

12. Système selon l'une quelconque des revendications 7 à 11, **caractérisé par le fait que** lesdits seconds moyens de détermination (17) comprennent :

- des quatrièmes moyens de calcul (27) destinés à calculer, pour chaque séquence candidate complète, une énergie de corrélation complète à partir de ladite séquence candidate complète et de la séquence reçue $(r_0 r_1 ... r_{M-1})$ ;
- des seconds moyens de sélection (28) destinés à sélectionner une séquence candidate complète ayant l'énergie de corrélation complète la plus élevée ; et
- des moyens de démappage (29) destinés à déterminer la séquence de N bits correspondante $(\hat{x}_0 \hat{x}_1 ... \hat{x}_{N-1})$ à partir de ladite séquence candidate complète sélectionnée.

13. Appareil de réception, notamment un téléphone mobile cellulaire (TP), **caractérisé par le fait qu'**il comporte un système selon l'une quelconque des revendications 7 à 12.

# FIG.1

EP 1 564 894 B1

## FIG.2

$X_0X_1....X_{N-1}$ → | Encoding | $C_0C_1....C_{M-1}$ → | Mapping | ⟶ ▽ 6 / 7

3 / 2 / 4 / 5

8 ▽ / 10 → | Demodulating | $r_0r_1....r_{M-1}$ → | Estimating | → $\hat{X}_0\hat{X}_1....\hat{X}_{N-1}$

9 / 11 / 1 / 14

~13

$S_0S_1....S_{M_{RS}-1}$

12

# FIG.3

EP 1 564 894 B1

## FIG.4

EP 1 564 894 B1

# FIG.5

31

Determining candidate
sequences of M$_{RS}$ digital data
from a reduced reference
sequence space

32

Making up each candidate
sequence to obtain at least
one complete candidate sequence
of M digital data

33

Determining the sequence of
N bits from all the complete
candidate sequences

EP 1 564 894 B1

M=18

M_RS=12

| $r_0=-2$ | $r_1=1$ | $r_2=-2$ | $r_3=-4$ | $r_4=7$ | $r_5=-3$ | $r_6=-2$ | $r_7=-1$ | $r_8=-2$ | $r_9=5$ | $r_{10}=4$ | $r_{11}=-3$ | $r_{12}=-3$ | $r_{13}=-1$ | $r_{14}=2$ | $r_{15}=5$ | $r_{16}=7$ | $r_{17}=-3$ |

$E_{max,end}^{M-M_{RS}}$ 21

| $S_0=-1$ | $S_1=-1$ | $S_2=1$ | $S_3=1$ | $S_4=-1$ | $S_5=-1$ | $S_6=-1$ | $S_7=-1$ | $S_8=-1$ | $S_9=1$ | $S_{10}=1$ | $S_{11}=-1$ |

8 $E_{max,end}^{M-M_{RS}}$ 21

25

2 $E_{max,end}^{M-M_{RS}}$ 21

18 $E_{max,end}^{M-M_{RS}}$ 21

6 $E_{max,end}^{M-M_{RS}}$ 21

Candidate reduced sequences

Threshold=25

FIG.6

FIG.7

Threshold=34

Candidate reduced sequences

EP 1 564 894 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Mikko Kokkonen et al.** Soft-Decision Decoding of Binary Linear Block Codes Using t-Algorithm. *IEEE,* 1997, 1181-1185